Europäisches Patentamt

European Patent Office

Office européen des brevets

(11) Publication number: **0 462 416 A2**

# EUROPEAN PATENT APPLICATION

(21) Application number: **91108377.2**

(22) Date of filing: **23.05.91**

(51) Int. Cl.⁵: **H01L 21/82**

(30) Priority: **24.05.90 US 528635**

(43) Date of publication of application:
**27.12.91 Bulletin 91/52**

(84) Designated Contracting States:
**DE**

(71) Applicant: **MICRON TECHNOLOGY, INC.**
**2805 East Columbia Road**
**Boise, ID 83706(US)**

(72) Inventor: **Ruojia, Lee**
**3351 Raindrop Drive**
**Boise Idaho 83706-5255(US)**

(74) Representative: **Klunker . Schmitt-Nilson .**
**Hirsch**
**Winzererstrasse 106**
**W-8000 München 40(DE)**

(54) **Process for N-well and P-well creation on a silicon substrate using a blanket P-well implant and no N-well steam oxidation step.**

(57) An improved process for N-well and P-well creation on a silicon substrate (12). Like the convention process, the improved process begins with the thermal growth of a pad oxide layer (11) on top of the substrate (12). A blanket (unmasked) boron P-well implant creates a boron-bearing P-type layer of substrate (21). Future P-well regions are then masked with photoresist (22). Pad oxide that is not subjacent the photoresist (22) is etched away, as is a portion of the boron-bearing layer (21) beneath the etched pad oxide. These recessed regions, which will become the N-well regions, are then subjected to a phosphorus implant which creates N-well (23). The concentration of the phosphorus implant is high enough to overwhelm any remaining boron atoms in N-well region (23). Following a photoresist strip, a high-temperature drive step in an oxygen ambient is performed, extending the depth of both well regions and creating a thermal oxide layer (24) on top of both P-type layer region (21) and N-well region (23). Growth of the thermal oxide layer (24) heals any imperfections in the silicon crystal structure that were sustained during the silicon etch. The thermal oxide layer (24) is then stripped and a gate oxide layer (25) is grown. This invention significantly reduces the number of steps required to create N-well and P-well regions on a silicon substrate by eliminating the need for a nitride deposition step and a steam oxidation step, both of which are utilized by the conventional process.

FIG. 16

EP 0 462 416 A2

Field of the Invention

This invention relates to manufacturing processes used to create multilayer semiconductor circuit devices on silicon substrates. More specifically, it relates to CMOS processes, which typically begin with the creation of N-wells and P-wells on a silicon substrate.

Background of the Invention

Although MOS integrated circuit devices are often referred to as "semiconductor" devices, such devices are fabricated from various materials which are either electrically conductive, electrically nonconductive or electrically semiconductive. Silicon, the most commonly used semiconductor material can be made conductive by doping it with either an element such as boron which has one less valence electron than silicon, or with an element such as phosphorus or arsenic which have one more valence electron than silicon. In the case of boron doping, electron "holes" become the charge carriers and the doped silicon is referred to as positive or P-type silicon. In the case of phosphorus or arsenic doping, the additional electrons become the charge carriers and the doped silicon is referred to as negative or N-type silicon. Silicon is used either in single-crystal or polycrystalline form. Polycrystalline silicon is referred to hereinafter as "polysilicon" or simply as "poly". Originally, MOS devices were manufactured from metal (used as the transistor gate), semiconductor material (used as the transistor channel material), and oxide (used as the dielectric between the gate and the substrate. Currently, however, most MOS transistors are fabricated using a conductively-doped polycrystalline silicon layer for the gate material. Another dielectric, such as silicon nitride, could readily be utilized as a replacement for the standard oxide dielectric.

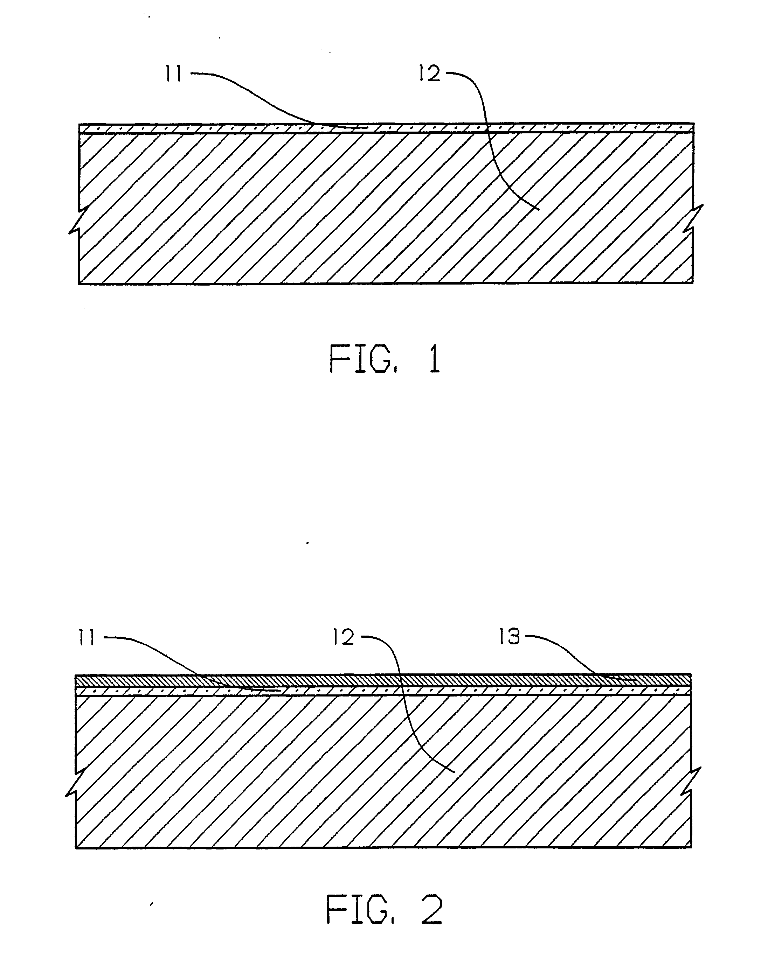

CMOS circuits utilize both N-type and P-type transistors, which function in a complementary fashion. During a CMOS manufacturing process, a silicon wafer is subjected to an ordered series of steps, which may include photomasking, material deposition, oxidation, nitridization, ion implantation, diffusion and etching, in order to achieve a final product. Typically, the process begins with the creation of N-wells and P-wells in a silicon substrate. Figures 1 through 9 illustrate the conventional N-well and P-well formation process.

Referring to Figure 1, a pad oxide layer 11 is thermally grown on a lightly-doped P-type silicon wafer substrate 12.

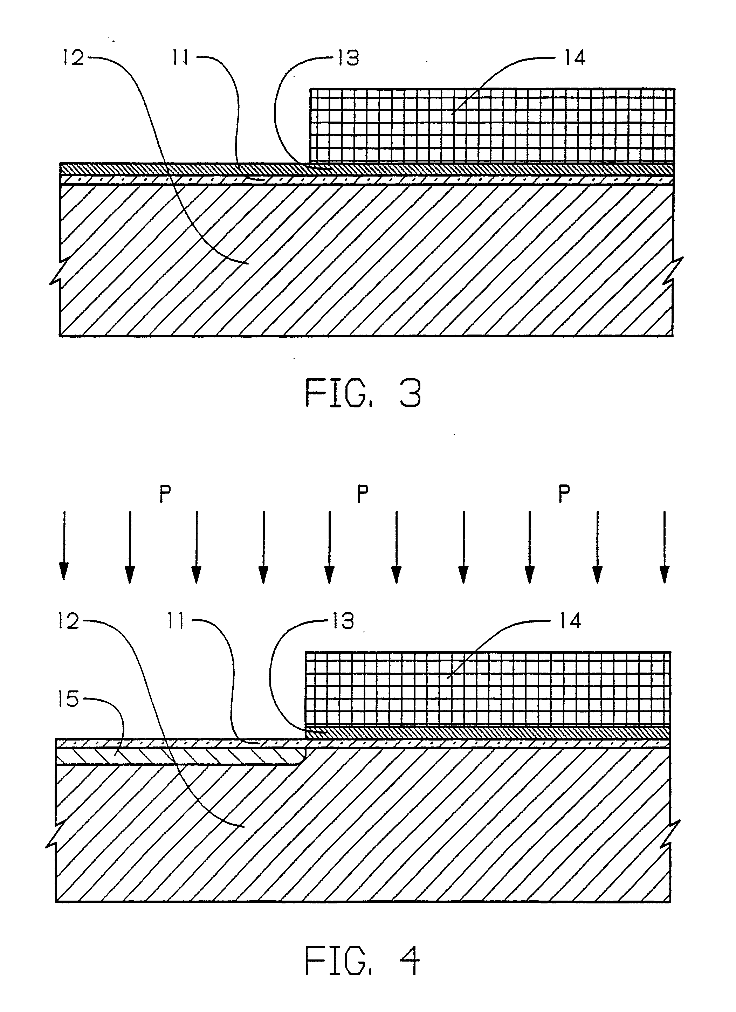

Referring to Figure 2, a silicon nitride layer 13 is deposited on top of pad oxide layer 11.

Referring to Figure 3, future P-well regions on the substrate are masked with a photoresist layer 14.

Referring to Figure 4, the wafer is subjected to a nitride etch, which removes those portions of silicon nitride layer 13 that are not subjacent photoresist layer 14. These regions where the nitride is removed correspond to the future N-well regions. A phosphorus implant then creates N-well regions 15 (only one such region is shown in Figure 4).

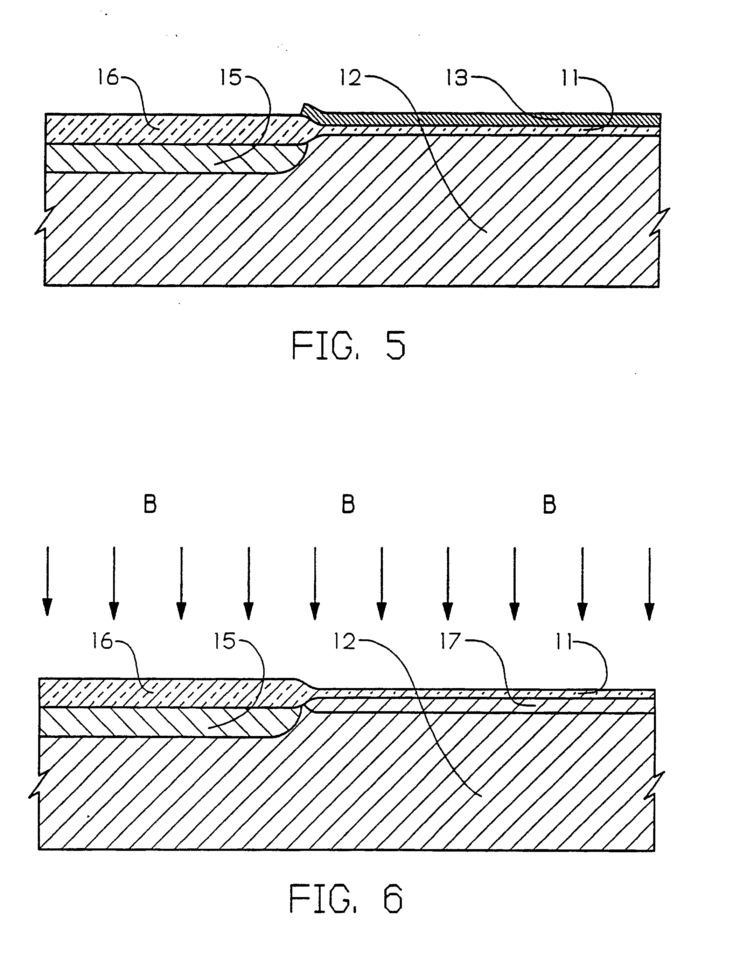

Referring to Figure 5, following a photoresist strip, a silicon oxide masking layer 16 is grown in the N-well regions 15 during a steam oxidation step. It will be noted that the steam-well oxidation recesses only the N-well regions 15. The pattern of recesses N-well regions on the wafer is commonly used for the alignment of subsequent photomasks. During the steam oxidation step, the phosphorus atoms in the N-well regions 15 diffuse somewhat deeper into the substrate 12 and under the uplifted edge of nitride layer 13.

Referring to Figure 6, the wafer is subjected to a boron implant which creates P-well regions 17 (only one such region is shown in figure 6). The silicon oxide masking layer 16 prevents the penetration of boron atoms into N-well regions 15. It will be noted that both the phosphorus implant depicted in Figure 4 and the boron implant depicted in Figure 6 were made through pad oxide layer 11. Implanting through an oxide layer tends to partially deflect implanted atoms, and thus eliminate the channeling tendency that occurs when an implant is made directly into a monocrystalline silicon layer. Channeling is the propensity of a high-energy particle to travel through a silicon crystal lattice if it enters the lattice such that it travels between layers of regularly-oriented silicon atoms. Small particles, such as boron atoms are more prone to channeling. Because of the more diverse arrangement of molecules in a silicon oxide layer, the layer will tend to deflect implanted particles in a random manner, thus allowing only a small percentage of the particles to engage in channeling.

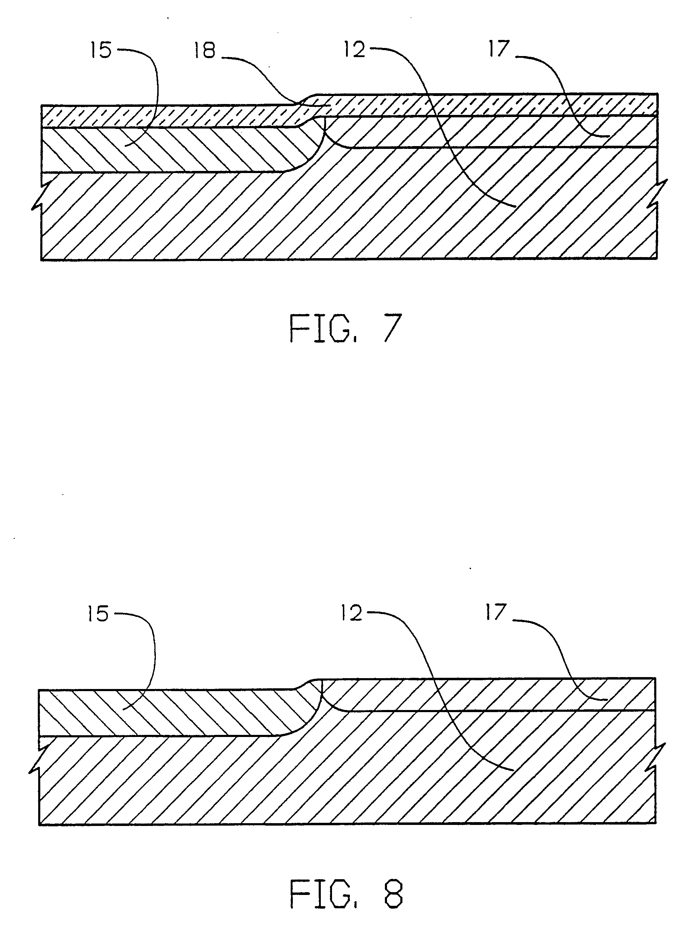

Referring to Figure 7, pad oxide layer 11 and masking oxide layer 16 have been removed with a first oxide etch, and a high-temperature drive step has caused the phosphorus atoms in N-well region 15 and the boron atoms in P-well region 17 to diffuse, thereby increasing the depth of each region. During the drive step, a thermal oxide layer 18 is typically grown on top of the N-well region 15 and the P-well region 17.

Referring now to Figure 8, a second oxide etch has removed thermal oxide layer 18.

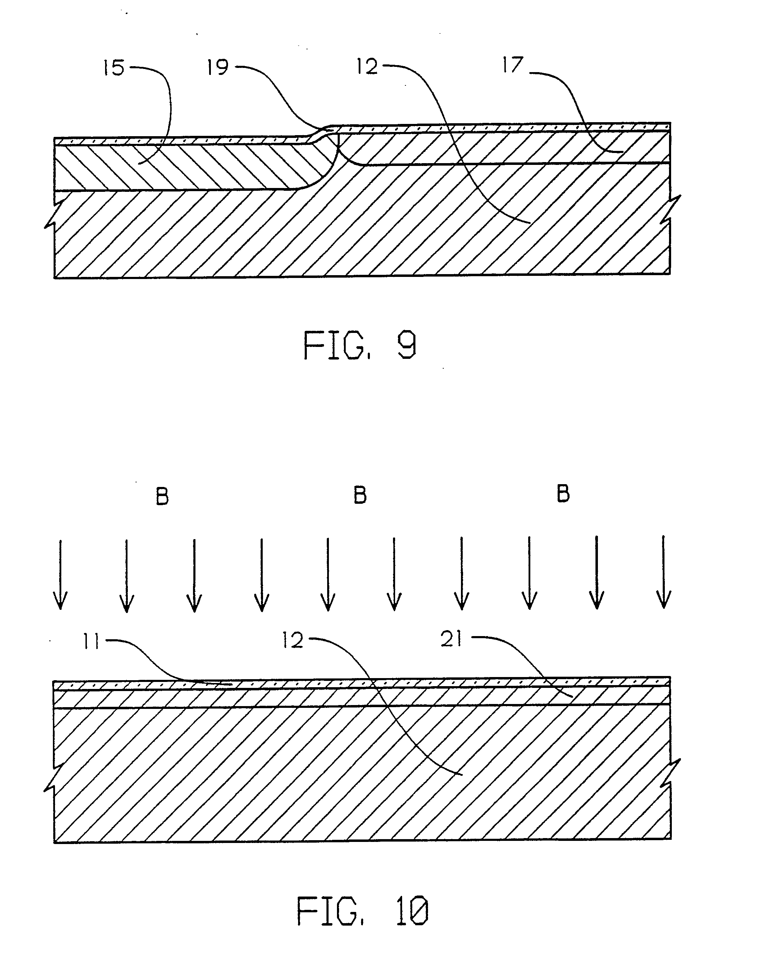

Referring now to Figure 9, a gate oxide layer 19 has been grown on both N-well regions 15 and P-well regions 17. Additional processing is of course required to complete the CMOS circuitry.

The process described above is extensively used in the semiconductor industry. If the process has a drawback, it is the high number of process steps involved. Greater competitiveness in the semiconductor industry is generally achieved by decreasing process steps, increasing chip density, and increasing product yield. If the number of process steps could be reduced during the N-well and P-well creation stage of CMOS circuit manufacture with no decrease in the quality of the circuitry, this would represent an advance in the art of semiconductor manufacturing.

Summary of the Invention

The present invention significantly reduces the number of steps required to create N-well and P-well regions on a silicon substrate. Like the conventional process, the improved process begins by growing a layer of thermal oxide on the substrate. However the nitride deposition step is eliminated. The steam oxidation step, which heretofore was required to create a thick oxide mask on top of the N-well regions, is also eliminated. A blanket (unmasked) boron P-well implant replaces the steam-oxide-masked P-well implant of the conventional process. Following the blanket P-well implant, the P-well regions are masked with photoresist and the N-well regions are recessed with a silicon etch. This recess step not only removes most of the implanted boron atoms, but also provides a very sharply defined step where the recess etch ends. This sharply-defined step allows more accurate alignment of subsequent photomasks, a feature that will prove to be increasingly significant as circuit density increases. The photoresist serves as a mask during a phosphorus N-well implant. Since phosphorus is a relatively large atom, channeling is not a significant problem.

Using this new improved N-well and P-well formation process, approximately fifty percent of the processing costs can be eliminated during this stage of circuit manufacture.

Brief Description of the Drawings

Figures 1 through 9 depict the prior art N-well/P-well formation process flow, while figures 1 and 10 through 16 depict the improved process flow.
Figure 1 is a cross-sectional view of a portion of a silicon wafer, showing a silicon substrate covered by a pad or denuding oxide layer;
Figure 2 is a cross-sectional view of the wafer portion of Figure 1 following the deposition of a silicon nitride layer;
Figure 3 is a cross-sectional view of the wafer portion of Figure 2 following the masking of future P-well regions with photoresist;

Figure 4 is a cross-sectional view of the wafer portion of Figure 3 following a phosphorus N-well implant;
Figure 5 is a cross-sectional view of the wafer portion of Figure 4 following steam oxidation of N-well regions;
Figure 6 is a cross-sectional view of the wafer portion of Figure 5 following a boron P-well implant;
Figure 7 is a cross-sectional view of the wafer portion of Figure 6 following a high-temperature drive step and growth of a thermal oxide layer;
Figure 8 is a cross-sectional view of the wafer portion of Figure 7 following removal of the thermal oxide layer;
Figure 9 is a cross-sectional view of the wafer portion of Figure 8 following the growth of gate oxide;
Figure 10 is a cross-sectional view of the wafer portion of Figure 1 following a blanket boron P-well implant;
Figure 11 is a cross-sectional view of the wafer portion of Figure 10 following the masking of P-well regions with photoresist;
Figure 12 is a cross-sectional view of the wafer portion of Figure 11 following an etch of the pad oxide layer and the substrate in the N-well regions;
Figure 13 is a cross-sectional view of the wafer portion of Figure 12 following a phosphorus N-well implant;
Figure 14 is a cross-sectional view of the wafer portion of Figure 13 following photoresist strip, a high-temperature drive step and growth of a thermal oxide layer;
Figure 15 is a cross-sectional view of the wafer portion of Figure 14 following removal of the thermal oxide layer with an oxide etch; and
Figure 16 is a cross-sectional view of the wafer portion of Figure 15 following the growth of a gate oxide layer.

Preferred Embodiment of the Invention

The improved process for N-well and P-well creation on a silicon substrate begins with the thermal growth of a silicon dioxide layer 11 on the silicon substrate 12. In the conventional process this thermal oxide layer serves as a pad oxide layer, which decouples mechanical stresses that would otherwise be transmitted to the substrate 12 by the silicon nitride layer that is subsequently deposited and used as used as a mask during the steam oxidation process. Hence, Figure 1 is representative of the first step both of the conventional process and the improved process. Although silicon dioxide layer 11 is not used as a stress-relief layer in the improved process, its growth is the result of a thermal step which causes oxygen molecules, which are trapped during silicon ingot formation, to migrate to the surface. Expulsion of oxygen molecules from the surface, in what is often referred to a denuding process, tends to reduce silicon defects which would otherwise reduce semiconductor efficiency in the completed circuit. In the improved process, silicon dioxide layer 11 will be referred to as a denuding oxide layer.

Referring now to Figure 10, the oxide-coated substrate 12 is subjected to unmasked implantation with a P-type impurity, such as boron, which creates a P-type material layer 21 on the surface of substrate 12. Since boron is a relatively small atom, the denuding oxide layer 11 also reduces the channeling tendency of the boron atoms.

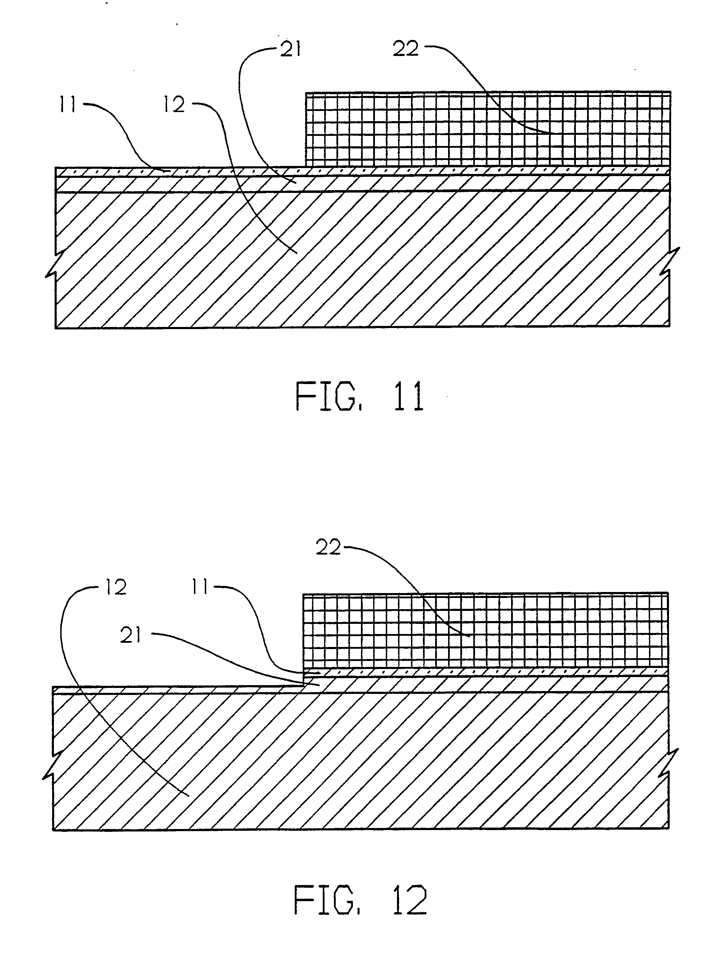

Referring now to Figure 11, future P-well regions are masked with photoresist 22.

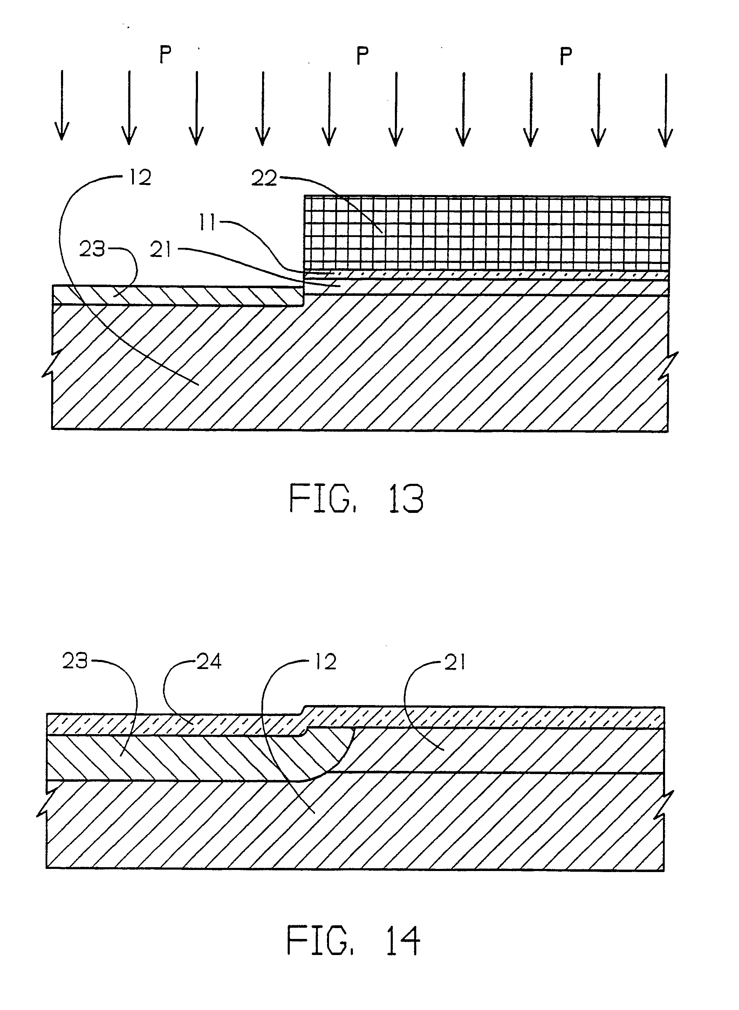

Referring now to Figure 12, the wafer is subjected, firstly, to an oxide etch which removes portions of denuding oxide layer 11, and, secondly, to a silicon etch which recesses portions of the substrate 12 that are not subjacent photoresist 22 approximately 1000 angstroms below the original level. Although a two-step in-situ plasma etch is the preferred etch technique, either a two-step acid etch or a combination of a plasma etch and an acid etch may be used. The recessed substrate regions will become the N-well regions, and the step between the recessed substrate regions and the raised P-well regions will be used to align subsequent masking steps. Recessing the future N-well regions also has the added advantage of removing a large portion of the boron atoms which were implanted during the blanket implant step depicted in Figure 10.

Referring now to Figure 13, the wafer is subjected to implantation with an N-type impurity, such as phosphorus, which overwhelms any remaining boron atoms in the future N-well regions and creates an N-well 23 in the substrate wherever substrate 12 is not masked with photoresist 22. Since phosphorus is a relatively large atom, it is not very susceptible to channeling. Hence, the absence of denuding oxide layer 11 in the future N-well regions during the phosphorus implant is insignificant.

Referring now to Figure 14, following the stripping of photoresist 22, the wafer is subjected to a high temperature drive step in an oxygen ambient, which causes the boron atoms in P-type layer 21 and the phosphorus atoms in N-well 23 to diffuse deeper into the substrate. The presence of oxygen during the drive step causes the growth of thermal silicon dioxide layer 24. The growth of thermal silicon dioxide layer 24 tends to heal any crystal defects on the surface of the silicon in the N-well regions that may have been created by the substrate-recessing silicon etch described with reference to Figure 12. Optionally, the high-temperature drive step may be performed principally in an anaerobic ambient, with oxygen being introduced during the drive step for a period sufficient to create a gate oxide layer of optimum thickness. Using this optional process flow, conventional processing to create completed circuitry would continue from this point.

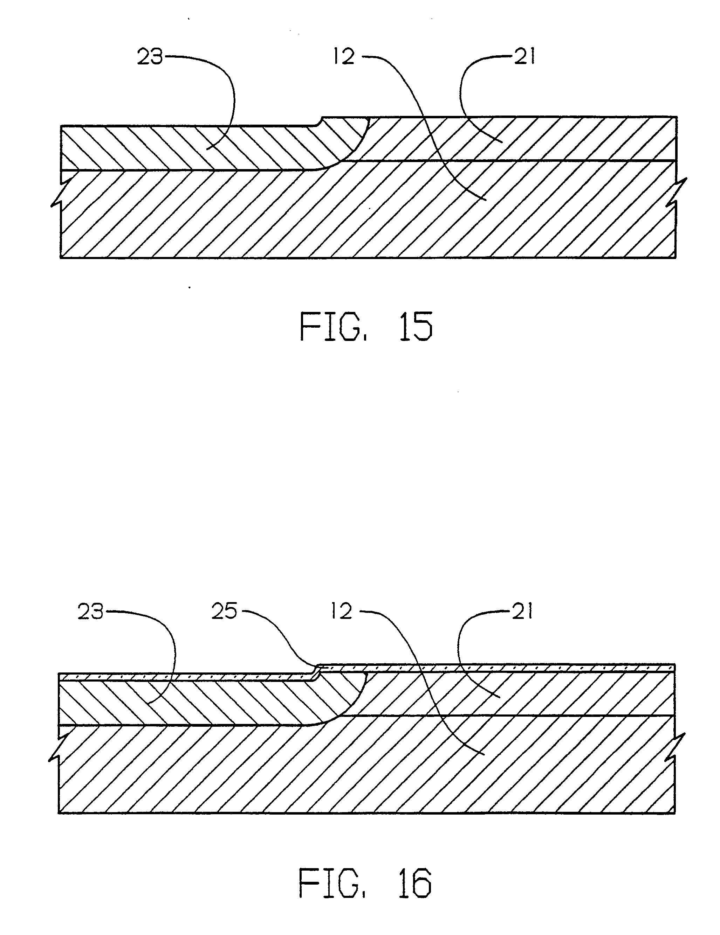

Referring now to Figure 15, thermal silicon dioxide layer 24 has been removed with a wet oxide etch.

Processing of the wafer to create completed circuitry may now proceed using conventional processing technology. Growth of a gate oxide layer is typically the first step in the conventional processing sequence.

Although only several embodiments of the present invention have been described herein, it will be apparent to one of ordinary skill in the art, that changes may be made thereto without departing from the spirit and the scope of the process as claimed.

## Claims

1. An improved process for N-well and P-well creation within the silicon substrate of a wafer, said process comprising the following steps:

   a) thermal oxidation of the wafer substrate (12) to create a denuding silicon dioxide layer (11) thereon;

   b) subjecting the wafer to unmasked implantation of a P-type impurity in order to create a ·P-type material layer (21) in the substrate (12);

   c) masking future P-well regions with photoresist (22);

   d) etching away those portions of the denuding layer (11) that are not subjacent photoresist (22);

   e) recessing those portions of the substrate that are not subjacent photoresist (22);

   f) subjecting the wafer to implantation of an N-type impurity in order to create N-well (23);

   g) stripping the photoresist (22); and

   h) subjecting the wafer to a high-temperature drive step which causes atoms of the implanted P-type impurity and implanted N-type impurity to diffuse deeper into the substrate (12), thus extending the depth of P-type material layer (21) and N-well (23) .

2. The improved process of Claim 1 wherein the P-type impurity implantation is performed using boron atoms.

3. The improved process of Claim 1 wherein the N-type impurity implantation is performed with phosphorus atoms.

4. The improved process of Claim 1 wherein the P-type impurity implantation is performed using boron atoms and the N-type impurity implantation is performed with phosphorus atoms.

5. The improved process of any preceding Claim wherein said high-temperature drive step is performed in an oxygen ambient, which causes a layer of thermal silicon dioxide (24) to form on top of both P-type material layer regions (21) and N-well regions (23).

6. The improved process of Claim 5, which further comprises the step of stripping the thermal silicon dioxide layer (24).

7. The improved process of Claim 6 which further comprises the step of creating a gate oxide layer (25) following the stripping of the thermal silicon dioxide layer (24).

8. The improved process of Claim 5, wherein growth of the thermal silicon dioxide layer (24) is controlled such that its thickness is optimum for use as a gate oxide layer (25).

FIG. 1

FIG. 2

12  11  13  14

## FIG. 3

P          P          P

12  11  13  14

15

## FIG. 4

FIG. 5

FIG. 6

FIG. 7

FIG. 8

FIG. 9

FIG. 10

FIG. 11

FIG. 12

P          P          P

12    22

11

23    21

FIG. 13

23    24    12    21

FIG. 14

FIG. 15

FIG. 16

13